# EUROPÄISCHE PATENTANMELDUNG

(11) **EP 4 844 293 A1**
(43) Veröffentlichungstag der Anmeldung: **25.11.2026**
(21) Anmeldenummer: 25178662.0
(22) Anmeldetag: 23.05.2025
(51) Int. Cl.: F24F 8/108, B01D 46/00, F04D 29/70, F24F 13/08, F24F 13/28, H05K 7/20

(54) **GRUNDGEHÄUSE FÜR EINEN FILTERLÜFTER ODER EINEN AUSTRITTSFILTER MIT SCHUTZEINRICHTUNG**

(71) Anmelder: Pfannenberg GmbH, 21035 Hamburg (DE)
(72) Erfinder: Cramer, Aaron, 21035 Hamburg (DE); Matthes, Simon, 21035 Hamburg (DE); Müller, Philipp, 21035 Hamburg (DE); Preißer, David, 21035 Hamburg (DE)
(74) Vertreter: RGTH

(57) **Zusammenfassung**

Um ein Grundgehäuse für einen Austrittsfilter oder Filterlüfter bereitzustellen, welches einen verbesserten Schutz vor Feuchtigkeit bietet, wird ein Grundgehäuse (100) vorgeschlagen für einen Filterlüfter oder einen Austrittsfilter, aufweisend eine flächige Schutzeinrichtung (10), welche eine Luftdurchtrittsöffnung (11) des Grundgehäuses (100) abdeckt, wobei die Schutzeinrichtung (10) wenigstens eine erste Schutzelementgruppe aufweist, deren Schutzelemente (12) eine erste Anlageebene (A1) für ein in dem Grundgehäuse (100) anordbares Filterelement (14) aufspannen, wobei das Grundgehäuse (100) an einer Luftdurchtrittsseite eine Rückseite (15) mit einer Rückseitenebene (RE) aufweist, wobei die erste Anlageebene (A1) relativ zur Rückseitenebene (RE) zum Inneren des Grundgehäuses (100) hin versetzt angeordnet ist.

## Beschreibung

Die Erfindung betrifft ein Grundgehäuse für einen Filterlüfter oder einen Austrittsfilter sowie einen Filterlüfter oder einen Austrittsfilter aufweisend ein solches Grundgehäuse.

Zur Klimatisierung eines Innenraums, beispielsweise eines Innenraums eines Schaltschranks, sind Filterlüfter bekannt, welche eine Lüfterfördereinrichtung, beispielsweise ein Lüfterrad, aufweisen sowie einen Filter zur Filterung von von der Lüfterfördereinrichtung in den Innenraum hinein oder aus dem Innenraum heraus geförderter Luft. Weist die Filteranordnung keinen Lüfter, sondern nur einen Filter auf, spricht man häufig auch von Austrittsfiltern. Auch beim Austrittsfilter kann die Luft in beide Richtungen durch den Austrittsfilter strömen, je nach Einbausituation. Der Filterlüfter oder Austrittsfilter weist in der Regel ein Grundgehäuse auf, wobei der Filterlüfter oder Austrittsfilter mittels des Grundgehäuses in einer Wandöffnung des Schaltschranks angeordnet ist.

Solche Austrittsfilter oder Filterlüfter umfassen häufig Berührungsschutzgitter, welche an einer Vorderseite oder Rückseite des Grundgehäuses angeordnet sind und verhindern sollen, dass Objekte in das Grundgehäuse geraten oder aus Versehen in das Grundgehäuse und in einen darin befindlichen Lüfter gegriffen wird. Ferner können Austrittsfilter oder Filterlüfter ein Filterelement umfassen zur Filterung der Luft, wobei das Filterelement in Bezug auf die Größe an dessen Aufnahmebereich in dem Grundgehäuse angepasst ist.

Im Betrieb des Austrittsfilters oder des Filterlüfters kann es zum Eindringen von Feuchtigkeit in das Grundgehäuse kommen. Je nach Bauart des Grundgehäuses kann es dabei dazu kommen, dass die Feuchtigkeit an dem Filtermedium herunterläuft und dabei in das Innere des Schaltschranks läuft, wenn das Filterelement direkt an einer Rückseite des Grundgehäuses anliegt.

Der Erfindung liegt somit die Aufgabe zugrunde, ein Grundgehäuse für einen Austrittsfilter oder Filterlüfter bereitzustellen, welches einen verbesserten Schutz vor Feuchtigkeit bietet.

Die erfindungsgemäße Aufgabe wird gelöst durch ein Grundgehäuse für einen Filterlüfter oder einen Austrittsfilter, aufweisend eine flächige Schutzeinrichtung, welche eine Luftdurchtrittsöffnung des Grundgehäuses abdeckt, wobei die Schutzeinrichtung wenigstens eine erste Schutzelementgruppe aufweist, deren Schutzelemente eine erste Anlageebene für ein in dem Grundgehäuse anordbares Filterelement aufspannen, wobei das Grundgehäuse an einer Luftdurchtrittsseite eine Rückseite mit einer Rückseitenebene aufweist, wobei die erste Anlageebene relativ zur Rückseitenebene zum Inneren des Grundgehäuses hin versetzt angeordnet ist.

Der Filterlüfter und der Austrittsfilter sind bevorzugt zur Klimatisierung eines Schaltschranks vorgesehen. Dazu kann der Filterlüfter bzw. der Austrittfilter mit dem Grundgehäuse in eine Wandöffnung des Schaltschranks eingesetzt sein, um entweder Luft in das Innere des Schaltschranks zu fördern oder Luft aus dem Schaltschrank hinauszufördern bzw. die durch den Filterlüfter bzw. Austrittfilter strömende Luft zu filtern.

Das Grundgehäuse weist eine Luftdurchtrittsöffnung auf, durch welche Luft durch das Grundgehäuse strömt. An der Luftdurchtrittsseite, an der die Luftdurchtrittsöffnung angeordnet ist, kann Luft aus dem Grundgehäuse herausströmen oder hineinströmen. An der Luftdurchtrittsseite ist eine Rückseite des Grundgehäuses angeordnet. Insbesondere weist das Grundgehäuse eine weitere Luftdurchtrittsseite an einer Vorderseite des Grundgehäuses auf, durch welche die Luft ebenfalls aus dem Gehäuse herausströmen oder in das Gehäuse hineinströmen kann. Eine Rückseite ist insbesondere jene Seite des Grundgehäuses, welche in einem Einbauzustand einem Innenraum bzw. einem zu klimatisierenden Bereich zugewandt ist. Ist das Grundgehäuse in einem Schaltschrank angeordnet, ist die Rückseite dem Schaltschrankinneren zugewandt. Die Luft kann bevorzugt von der Vorderseite zu der Rückseite des Grundgehäuses strömen oder umgekehrt von der Rückseite zur Vorderseite. Die Strömungsrichtung kann insbesondere durch eine Drehrichtung eines in dem Grundgehäuse angeordneten Lüfters bestimmt sein.

Die Luft tritt insbesondere durch die Schutzeinrichtung in das Grundgehäuse. Die Schutzeinrichtung ist somit insbesondere luftdurchlässig. Die Schutzeinrichtung erstreckt sich insbesondere vollständig über eine Öffnungsfläche der Luftdurchtrittsöffnung, sodass bevorzugt der gesamte durch das Grundgehäuse strömende Luftstrom durch die Schutzeinrichtung strömt. Insbesondere ist die Schutzeinrichtung in der Luftdurchtrittsöffnung angeordnet.

Durch die nach innen in das Innere des Grundgehäuses versetzte Anordnung der ersten Anlagefläche relativ zu einer Rückseitenebene des Grundgehäuses wird vorteilhaft verhindert, dass Flüssigkeit über die Rückseite aus dem Grundgehäuse treten kann. Insbesondere wird dadurch verhindert, dass Feuchtigkeit aus dem Grundgehäuse in das Innere eines Schaltschranks gelangen kann, in dem das Grundgehäuse angeordnet ist. Dabei ist die Rückseite des Grundgehäuses dem Inneren des Schaltschranks zugewandt. Bei der Feuchtigkeit handelt es sich insbesondere um Wasser, welches sich in dem Filterelement gesammelt hat und welches an oder in dem Filterelement nach unten abläuft. Wäre das Filterelement im Bereich der Rückseitenebene angeordnet, könnte das Wasser in das Innere des Schaltschranks hinein ablaufen. Dadurch, dass eine Anlagefläche für das Filterelement nach innen in das Innere des Grundgehäuses versetzt angeordnet ist, wird vorteilhaft gewährleistet, dass das Wasser an dem Filterelement in das Innere des Grundgehäuses und nicht in das Innere des Schaltschranks abläuft. Ferner liegt das Filterelement an den Schutzelementen an der Schutzeinrichtung an, welche das Wasser entsprechend in das Innere des Grundgehäuses leiten können.

Bevorzugt ist die erste Anlageebene vollständig nach innen in das Innere des Schaltschranks hin versetzt zu der Rückseitenebene angeordnet. Insbesondere ist die Schutzeinrichtung als solche vollständig nach innen in das Innere des Schaltschranks hin versetzt zu der Rückseitenebene angeordnet. Bevorzugt erstrecken sich die erste Anlagefläche und die Rückseitenebene bezogen auf den Einbauzustand des Grundgehäuses jeweils senkrecht zur Strömungsrichtung von durch das Grundgehäuse strömender Luft.

Bevorzugt ist das Grundgehäuse im Wesentlichen rahmenförmig ausgebildet, wobei die Schutzeinrichtung und die Luftdurchtrittsöffnung im Inneren des Rahmens angeordnet sind. Das Grundgehäuse kann insbesondere vier Umfangsseitenwände aufweisen, welche im Einbauzustand des Grundgehäuses einer Wandöffnung zugewandt sind, in welcher das Grundgehäuse angeordnet ist. Die Schutzeinrichtung ist insbesondere zwischen Innenseiten der Umfangsseitenwände angeordnet. Eine Rückseite des Grundgehäuses ist insbesondere senkrecht zu den Umfangsseitenwänden angeordnet. Die Rückseite kann insbesondere eine Rückwand des Grundgehäuses sein.

Die erste Anlageebene für das Filterelement bildet insbesondere eine erste Anlagefläche für das Filterelement, wobei die Anlagefläche insbesondere nicht durchgehend ausgebildet ist, sondern durch eine Vielzahl in einer Ebene angeordnete Auflagepunkte oder Auflagebereiche, welche durch die einzelnen Schutzelemente gebildet sind, gebildet ist. Die erste Anlagefläche ist insbesondere dem Inneren des Grundgehäuses zugewandt. Die Schutzeinrichtung überdeckt das Filterelement somit an einer einer Umgebung des Grundgehäuses bzw. dem Schaltschrankinneren zugewandten Seite des Filterelements.

Bevorzugt tritt die Luft durch die erste Anlageebene durch das Grundgehäuse. Bevorzugt sind die erste Anlageebene und die Rückseitenebene parallel zueinander angeordnet. Bevorzugt ist die erste Anlageebene zwischen dem Filterelement und der Rückseitenebene angeordnet.

Die Rückseitenebene ist insbesondere eine rückseitige Fläche des Grundgehäuses. Bevorzugt ist das Grundgehäuse rahmenförmig ausgebildet. An der Rückseite ist bevorzugt eine im Wesentlichen rahmenförmige Fläche ausgebildet, mit welcher das Grundgehäuse rückseitig abschließt und welche die Rückseitenebene aufspannt. Die rahmenförmige Fläche umgibt insbesondere die Luftdurchtrittsöffnung. Bevorzugt umgibt die rahmenförmige Fläche die in der Luftdurchtrittsöffnung angeordnete Schutzeinrichtung.

Bevorzugt ist die Schutzeinrichtung vollständig nach innen versetzt hinter der Rückseitenebene angeordnet. Die Schutzeinrichtung erstreckt sich insbesondere nicht durch die Rückseitenebene hindurch.

Bevorzugt sind die Schutzelemente der ersten Schutzelementgruppe Streben, Stangen oder Lamellen. Die Schutzelemente erstrecken sich insbesondere parallel zueinander in der Luftdurchtrittsöffnung. Die Schutzelemente der ersten Schutzelementgruppe bilden insbesondere ein Gitter. Das Filterelement liegt insbesondere auf dem Gitter auf.

Bevorzugt sind die Schutzelemente der ersten Schutzelementgruppe horizontal oder vertikal angeordnet bezogen auf einen Einbauzustand des Grundgehäuses.

Bevorzugt weist die Schutzeinrichtung eine zweite Schutzelementgruppe auf, deren Schutzelemente eine zweite Anlageebene aufspannen für das in dem Grundgehäuse anordbare Filterelement, wobei die zweite Anlageebene relativ zur ersten Anlageebene zum Inneren des Grundgehäuses hin versetzt angeordnet ist. Die zweite Anlageebene für das Filterelement bildet insbesondere eine zweite Anlagefläche für das Filterelement, wobei die zweite Anlagefläche insbesondere nicht durchgehend ausgebildet ist, sondern durch eine Vielzahl in einer Ebene angeordnete Auflagepunkte oder Auflagebereiche gebildet ist, welche durch die einzelnen Schutzelemente der zweiten Schutzelementgruppe gebildet sind.

Bevorzugt ist die zweite Anlageebene parallel zu der ersten Anlageebene und der Rückseitenebene angeordnet. Bevorzugt ist die erste Anlageebene zwischen der zweiten Anlageebene und der Rückseitenebene angeordnet.

Bevorzugt sind die Schutzelemente der zweiten Schutzelementgruppe Streben, Stangen, Lamellen oder sich von den Schutzelementen der ersten Schutzelementgruppe erstreckende Vorsprünge. Die Schutzelemente erstrecken sich insbesondere parallel zueinander in der Luftdurchtrittsöffnung. Schutzelemente der zweiten Schutzelementgruppe bilden insbesondere ein Gitter. Das Filterelement liegt insbesondere auf dem Gitter auf.

Bevorzugt sind Schutzelemente der ersten Schutzelementgruppe gleich oder unterschiedlich zu den Schutzelementen der zweiten Schutzelementgruppe ausgebildet. Insbesondere können die Schutzelemente der ersten Schutzelementgruppe Stangen oder Lamellen sein und die Schutzelemente der zweiten Schutzelementgruppe können Streben oder sich von den Schutzelementen der ersten Schutzelementgruppe erstreckende Vorsprünge sein.

Bevorzugt sind die Schutzelemente innerhalb der ersten Schutzelementgruppe und/oder innerhalb der zweiten Schutzelementgruppe identisch ausgebildet.

Bevorzugt sind die Schutzelemente der zweiten Schutzelementgruppe horizontal oder vertikal angeordnet bezogen auf einen Einbauzustand des Grundgehäuses, wobei die Schutzelemente der zweiten Schutzelementgruppe bevorzugt senkrecht zu den Schutzelementen der ersten Schutzelementgruppe angeordnet sind. Insbesondere sind die Schutzelemente der ersten Schutzelementgruppe horizontal angeordnet und die Schutzelemente der zweiten Schutzelementgruppe sind vertikal angeordnet.

Bevorzugt sind die Schutzelemente der zweiten Schutzelementgruppe vertikal angeordnet derart, dass Wasser aus dem Filterelement vorteilhaft nach unten in das Innere des Grundgehäuses entlang der Schutzelemente geleitet werden kann. Somit gelangt das Wasser insbesondere nicht in das Innere des Schaltschranks.

Bevorzugt sind die Schutzelemente der zweiten Schutzelementgruppe von der Rückseite bzw. Rückwand des Grundgehäuse nach innen ausgeformte Streben. Endseitig weisen die Schutzelemente jeweils, insbesondere gebogen geformte, Verbindungsabschnitte auf, mittels welchen die Schutzelemente der zweiten Schutzelementgruppe an einer Innenseite der Rückwand des Grundgehäuses befestigt sind. Die Verbindungsabschnitte können Ausformungen darstellen, wobei zwischen diesen Ausformungen und den Innenwänden des Grundgehäuses jeweils ein Aufnahmeraum ausgebildet ist. In diese Aufnahmeräume, welche insbesondere an sich gegenüberliegenden Seiten des Grundgehäuses angeordnet sind, können sich entweder an einer oder an beiden Seiten hervorstehende Endabschnitte des Filterelements erstrecken.

Bevorzugt bilden die Schutzelemente der ersten Schutzelementgruppe und die Schutzelemente der zweiten Schutzelementgruppe gemeinsam ein Gitter.

Bevorzugt sind die Schutzelemente der ersten Schutzelementgruppe und die Schutzelemente der zweiten Schutzelementgruppe miteinander verbunden. Insbesondere können sich die Schutzelemente der zweiten Gruppe durchgehend über die Luftdurchtrittsöffnung erstrecken. Die Schutzelemente der ersten Schutzelementgruppe können sich jeweils zwischen zwei benachbarten Schutzelementen der zweiten Schutzelementgruppe senkrecht zu diesen erstrecken. Die Schutzelemente der ersten Schutzelementgruppe erstrecken sich insbesondere abschnittweise entlang mehrerer gedachter Linien senkrecht zu den Schutzelementen der zweiten Schutzelementgruppe über die Luftdurchtrittsöffnung. Dadurch bilden die Schutzelemente der ersten und der zweiten Schutzelementgruppe bevorzugt eine, insbesondere gleichmäßige, Gitterstruktur.

Ferner können die Schutzelemente der ersten Schutzelementgruppe und die Schutzelemente der zweiten Schutzelementgruppe separat voneinander ausgebildet und in Strömungsrichtung der Luft versetzt zueinander angeordnet sein.

Bevorzugt sind die Schutzelemente der zweiten Schutzelementgruppe horizontal oder vertikal angeordnet bezogen auf einen Einbauzustand des Grundgehäuses, wobei die Schutzelemente der zweiten Schutzelementgruppe bevorzugt senkrecht zu den Schutzelementen der ersten Schutzelementgruppe angeordnet sind.

Bevorzugt ist die Anzahl an Schutzelementen der ersten Schutzelementgruppe größer als eine Anzahl der Schutzelemente der zweiten Schutzelementgruppe. Insbesondere bilden die Schutzelemente der zweiten Schutzelementgruppe Verstärkungsstreben für die Schutzelemente der ersten Schutzelementgruppe. Beispielsweise kann eine Anzahl der Schutzelemente der zweiten Gruppe einer Hälfte, einem Drittel oder einem Viertel einer Anzahl der Schutzelemente der ersten Gruppe entsprechen.

Bevorzugt weist das Grundgehäuse ein Filterelement auf, wobei das Filterelement in der ersten Anlageebene an den Schutzelementen der ersten Schutzelementgruppe anliegt. Bevorzugt liegt das Filterelement ausschließlich an der ersten Anlageebene an.

Bevorzugt weist das Grundgehäuse ein Filterelement auf, wobei das Filterelement in der zweiten Anlageebene an den Schutzelementen der zweiten Schutzelementgruppe anliegt. Bevorzugt liegt das Filterelement ausschließlich an der zweiten Anlageebene an.

Bevorzugt kann das Filterelement sowohl an der ersten als auch an der zweiten Anlageebene an den Schutzelementen der ersten und der zweiten Schutzelementgruppe anliegen. Das Filterelement ist in diesem Fall insbesondere flächig und flexibel angeordnet, sodass es sowohl in der zweiten Anlageebene auf den Schutzelementen der zweiten Schutzelementgruppe aufliegen kann und sich zwischen den Schutzelementen der zweiten Schutzelementgruppe hin zu den Schutzelementen der ersten Schutzelementgruppe erstrecken kann und dort in der ersten Anlageebene anliegen kann.

Bevorzugt ist das Filterelement ein ebenes Filterelement oder ein Faltenfilterelement. Das ebene Filterelement ist insbesondere nicht gefaltet und das Filterelementmaterial erstreckt sich in einer Ebene. Das Filterelement kann insbesondere flexibel sein, bevorzugt in horizontaler Richtung und/oder in vertikaler Richtung bezogen auf den Einbaustand des Grundgehäuses. Das Filterelement kann dann sowohl in der ersten als auch in der zweiten Anlageebene an der Schutzeinrichtung bzw. den Schutzelementen anliegen.

Bevorzugt weist das Grundgehäuse ein Filterelement auf, welches in der zweiten Auflageebene an den Schutzelementen der zweiten Schutzelementgruppe anliegt, wobei das Filterelement ein ebenes Filterelement ist. Bevorzugt kann das ebene Filterelement ausschließlich an den Schutzelementen der zweiten Schutzelementgruppe anliegen. Das Filterelement ist in diesem Fall im Wesentlichen starr ausgebildet.

Sofern keine zweite Schutzelementgruppe vorhanden ist, kann das ebene Filterelement ausschließlich auf den Schutzelementen der ersten Schutzelementgruppe anliegen.

Bevorzugt ist das Filterelement ein Faltenfilterelement, welches an den Schutzelementen der ersten Schutzelementgruppe anliegt und wobei die Schutzelemente der zweiten Schutzelementgruppe sich in Falten des Faltenfilterelements erstrecken. Das Filterelement liegt in diesem Fall ausschließlich in der ersten Anlageebene an. Bevorzugt liegt das Faltenfilterelement mit Faltkanten des Faltenfilterelements auf den Schutzelementen der ersten Schutzelementgruppe an. Dadurch, dass sich die Schutzelemente der zweiten Schutzelementgruppe in die Falten des Faltenfilterelements erstrecken, kann vorteilhaft ein Verrutschen des Faltenfilters senkrecht zu den Schutzelementen der zweiten Schutzelementgruppe verhindert oder reduziert werden.

Bevorzugt erstrecken sich Faltkanten des Faltenfilters parallel zu den Schutzelementen der ersten Schutzelementgruppe oder parallel zu den Schutzelementen der zweiten Schutzelementgruppe.

Bevorzugt weist das Grundgehäuse eine Ausformung auf, wobei zwischen der Ausformung und einer Innenwand des Grundgehäuses wenigstens ein Aufnahmeraum ausgebildet ist. Die Innenwände des Grundgehäuses sind insbesondere Innenseiten der Umfangsseitenwände. Insbesondere weisen zumindest zwei sich gegenüberliegende oder sämtliche Innenwände des Grundgehäuses eine solche Ausformung auf, sodass sich die Luftdurchtrittsöffnung zwischen zwei Ausformungen erstreckt bzw. sich die Ausformung um die Luftdurchtrittsöffnung herum erstreckt. Der Aufnahmeraum kann bevorzugt umlaufend an allen vier Seitenflächen bzw. allen vier Innenwänden angeordnet sein. Insbesondere definiert die umlaufende Ausformung die Luftdurchtrittsöffnung im Bereich der Schutzeinrichtung.

Bevorzugt sind die Schutzelemente der Schutzeinrichtung an der Ausformung angeordnet. Bevorzugt sind einige oder sämtliche der Schutzelemente der ersten Schutzelementgruppe mit der Ausformung verbunden bzw. unmittelbar an dieser befestigt. Bevorzugt sind einige oder sämtliche der Schutzelemente der zweiten Schutzelementgruppe mit der Ausformung verbunden bzw. unmittelbar an dieser befestigt. Bevorzugt ist die Schutzeinrichtung ausschließlich über einige oder sämtliche der Schutzelemente der ersten Schutzelementgruppe oder ausschließlich über einige oder sämtliche der Schutzelemente der zweiten Schutzelementgruppe an der Ausformung befestigt. Ferner können die Schutzeinrichtung bzw. die Schutzelemente in analoger Weise auch direkt an der Innenwand des Grundgehäuses befestigt sein.

Die Ausformung erstreckt sich bevorzugt ausgehend von der Rückseite des Grundgehäuses. Insbesondere erstreckt sich die Ausformung ausgehend von der Rückseitenebene senkrecht zu dieser in das Innere des Grundgehäuses. Die Schutzeinrichtung bzw. die Schutzelemente sind an einer der Luftdurchtrittsöffnung zugewandten ersten Seitenfläche der Ausformung angeordnet. Eine der ersten Seitenfläche abgewandte zweite Seitenfläche der Ausformung ist dem Aufnahmeraum bzw. der Innenwand des Grundgehäuses zugewandt. Der Aufnahmeraum ist zwischen der zweiten Seitenfläche und der Innenwand des Grundgehäuses ausgebildet.

Bevorzugt erstreckt sich das Filterelement in den Aufnahmeraum.

Bevorzugt ist das Filterelement ein Faltenfilter, wobei sich bevorzugt wenigstens eine endseitige Falte des Faltenfilters in den Aufnahmeraum erstreckt. Bevorzugt sind wenigstens im Bereich zweier sich gegenüberliegender Innenwände jeweils eine Ausformung und jeweils ein Aufnahmeraum vorgesehen, sodass zwei endseitige Falten an zwei Enden des Faltenfilters sich je in einen Aufnahmeraum erstrecken können.

Ferner kann das Filterelement ein im Wesentlichen ebenes Filterelement sein, wobei an wenigstens einer, an zwei sich gegenüberliegenden Seiten oder an sämtlichen Seiten ein hervorstehender Endabschnitt vorgesehen sein kann, welcher bzw. welche sich jeweils in einen Aufnahmeraum an der jeweiligen Innenwand erstrecken kann bzw. können.

Ferner erstreckt sich das Filterelement in den Aufnahmeraum.

Die erfindungsgemäße Aufgabe wird ferner gelöst durch einen Filterlüfter oder einen Austrittsfilter, jeweils aufweisend ein Grundgehäuse gemäß einer der vorgenannten Ausführungsformen. Der Filterlüfter oder Austrittsfilter kann ferner einen Gehäusedeckel umfassen. Der Filterlüfter kann ferner eine Luftfördereinrichtung, insbesondere ein Lüfterrad bzw. ein Gebläse, umfassen.

Nachfolgend wird die Erfindung anhand von Ausführungsbeispielen näher erläutert. Es zeigen:
- Fig. 1: eine geschnittene, perspektive Darstellung auf einen Rückseitenbereich eines Grundgehäuses mit einer Schutzeinrichtung und einem Filterelement gemäß einer ersten Ausführungsform,
- Fig. 2: eine Draufsicht auf das Grundgehäuse mit einem Filterelement gemäß einer zweiten Ausführungsform,
- Fig. 3: eine Querschnittsansicht durch das Grundgehäuse aus Figur 2, und
- Fig. 4: eine perspektivische Ansicht des Grundgehäuses aus Figuren 2 und 3.

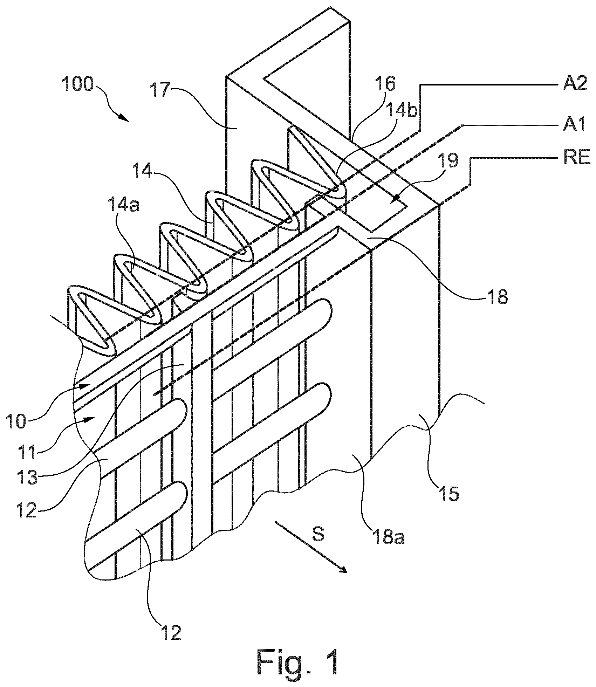

Figur 1 zeigt einen Rückseitenbereich eines Grundgehäuses 100 für einen Filterlüfter oder einen Austrittsfilter. Das Grundgehäuse 100 ist rahmenförmig ausgebildet, wobei Figur 1 das Grundgehäuse in einem Querschnitt durch die Umfangsseitenwände 16 zeigt.

Das Grundgehäuse 100 weist eine Luftdurchtrittsöffnung 11 auf, durch welche Luft in Strömungsrichtung S oder entgegengesetzt hierzu durch das Grundgehäuse 100 strömen kann. Das Grundgehäuse 100 weist eine Rückseite 15 auf, welche eine von zwei Luftdurchtrittsseiten des Grundgehäuses 100 bildet. Die Rückseite 15 weist eine rahmenförmige Rückwand auf, welche in einer Rückseitenebene RE des Grundgehäuses 100 angeordnet ist.

In der Luftdurchtrittsöffnung 11 ist eine Schutzeinrichtung 10 angeordnet, welche sich über die Öffnungsfläche der Luftdurchtrittsöffnung 11 erstreckt. Die Schutzeinrichtung 10 ist gitterförmig ausgestaltet mit Schutzelementen 12 einer ersten Schutzelementgruppe, welche sich vertikal über die Luftdurchtrittsöffnung 11 erstrecken. Die Schutzelemente 12 der ersten Schutzelementgruppe sind als horizontale Stangen ausgebildet, welche sich abschnittsweise zwischen Schutzelementen 13 einer zweiten Schutzelementgruppe erstrecken. Die Schutzelemente 12 bzw. deren nach innen ins Innere des Grundgehäuse 100 gewandte Seiten spannen eine erste Anlageebene A1 auf, an welcher ein Filterelement 14 bereichsweise anliegt.

Das Filterelement 14 ist ein Faltenfilter, wobei Faltkanten des Faltenfilters an den Schutzelementen 12 der ersten Schutzelementgruppe in der ersten Anlageebene A1 anliegen.

Die Schutzelemente 13 der zweiten Schutzelementgruppe erstrecken sich vertikal über die Luftdurchtrittsöffnung 11. Die Schutzelemente 13 bzw. deren nach innen ins Innere des Grundgehäuse 100 gewandte Seiten spannen eine zweite Anlageebene A2 auf. Die Schutzelemente 13 der zweiten Schutzelementgruppe erstrecken sich jeweils in eine Falte 14a des Faltenfilters. Dadurch kann vorteilhaft ein seitliches Verrutschen des Faltenfilters verhindert und reduziert werden. Das Filterelement kann alternativ ein ebenes Filterelement sein. In diesem Fall kann das Filterelement an der zweiten Anlageebene A2 anliegen.

Durch den vertikalen Verlauf der Schutzelemente 13 der zweiten Schutzelementgruppe kann vorteilhaft Wasser aus dem Filterelement nach unten in das Innere des Grundgehäuses 100 geleitet werden.

Das Grundgehäuse 100 weist ferner eine Ausformung 18 im Bereich der Rückseite 15 auf. Die Ausformung 18 erstreckt sich ausgehend von der Rückwand bzw. der Rückseite 15 senkrecht von der Rückseitenebene RE in das Innere des Grundgehäuses 100. An einer der Luftdurchtrittsöffnung 11 zugewandten Seitenfläche 18a der Ausformung ist die Schutzeinrichtung 10 befestigt. Die Schutzreinrichtung 10 erstreckt sich in einer vertikalen Ebene. Insbesondere sind die horizontalen Schutzelemente 12 der ersten Schutzelementgruppe an der Seitenfläche 18a der Ausformung 18 befestigt.

Die Ausformung 18 schließt einen Aufnahmeraum 19 mit einer Innenwand 17 des Grundgehäuses 100 ein. Eine endseitige Falte 14b des Filterelements 14 erstreckt sich in den Aufnahmeraum 19. Ist das Filterelement 14 eben ausgebildet, kann sich ein hervorstehender Endabschnitt in den Aufnahmeraum 19 erstrecken.

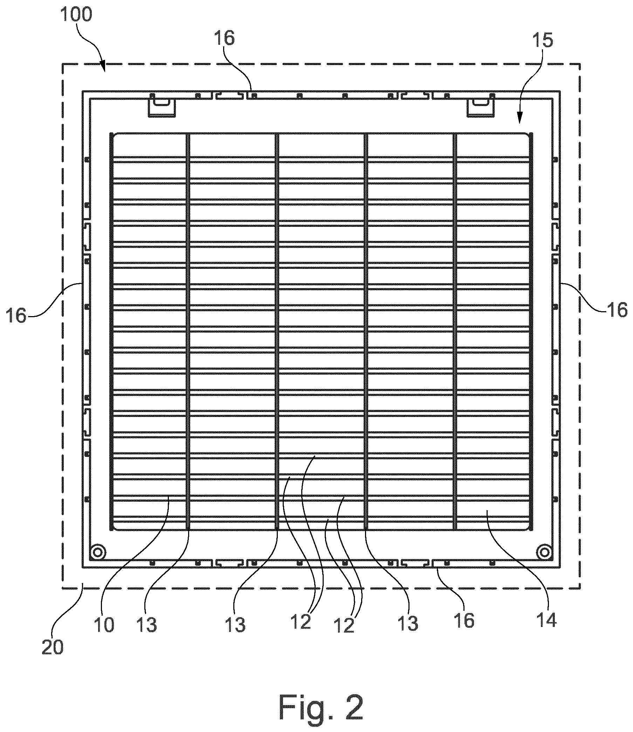

Figur 2 zeigt eine Draufsicht auf das Grundgehäuse 100 mit einem Filterelement 14 gemäß einer weiteren Ausführungsform. Das Filterelement 14 ist hier als ebener Filter ausgebildet. Ferner ist die gitterförmige Schutzeinrichtung 10 gezeigt mit den Schutzelementen 12 der ersten Schutzelementgruppe und den senkrecht dazu verlaufenden Schutzelementen 13 der zweiten Schutzelementgruppe. Das Grundgehäuse 100 ist rahmenförmig ausgestaltet mit einer Rückseite 15, dessen Rückseitenfläche ebenfalls rahmenförmig mit vier Umfangsseitenwänden 16 ausgebildet ist. Die Rückseitenfläche spannt die Rückseitenebene auf.

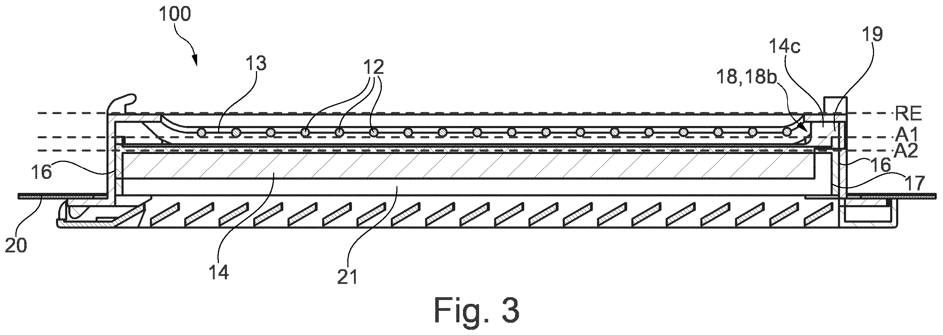

Figur 3 zeigt eine Querschnittsdarstellung durch das Grundgehäuse 100 aus Figur 2. Dargestellt ist das ebene Filterelement 14, welches endseitig einen senkrecht von der Ebene des Filterelements 14 hervorstehenden Endabschnitt 14c aufweist, welcher sich in einen Aufnahmeraum 19 des Grundgehäuses 100 erstreckt. Der Aufnahmeraum 19 ist zwischen einer Ausformung 18 und einer Innenwand 17 des Grundgehäuses 100 ausgebildet. Die Ausformungen 18 sind jeweils durch einen gebogen geformten Verbindungsabschnitt 18b gebildet, mittels welchem die Schutzelemente 13 der zweiten Schutzelementgruppe an einer Innenwand der Rückwand bzw. Rückseite 15 des Grundgehäuses 100 befestigt sind.

Ferner sind in Figur 3 die Rückseitenebene RE, die erste Anlagenebene A1 und die zweite Anlagenebene A2 gezeigt, wobei dargestellt ist, dass das ebene Filterelement 14 ausschließlich an den Schutzelementen 13 der zweiten Schutzelementgruppe in der zweiten Anlageebene A2 anliegt.

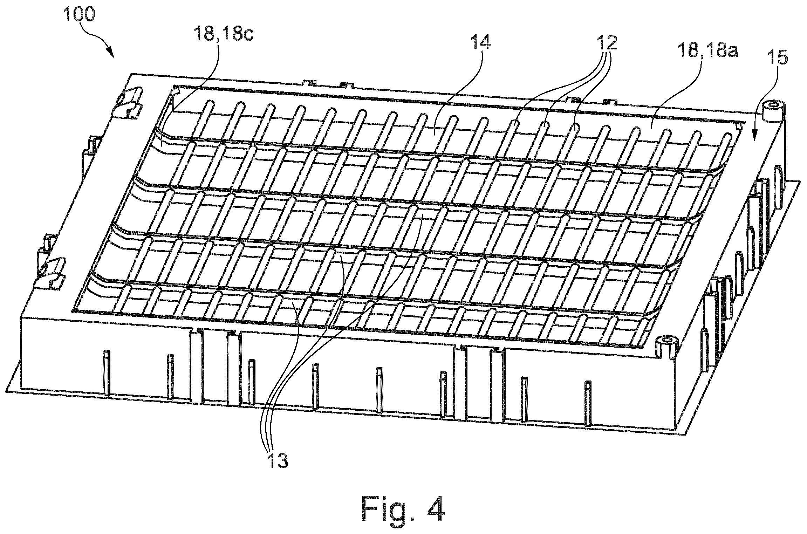

Figur 4 zeigt eine perspektivische Ansicht auf das Grundgehäuse 100. Es sind die Schutzelemente 12, 13 der ersten und zweiten Schutzelementgruppe gezeigt sowie die Ausformungen 18. Insbesondere ist gezeigt, dass die Schutzelemente 12 der ersten Schutzelementgruppe an Seitenflächen 18a von Ausformungen 18 an einem ersten Paar von sich gegenüberliegen Seiten des rahmenförmigen Grundgehäuses 100 angeordnet sind.

An dem weiteren Paar von sich gegenüberliegenden Seiten des Grundgehäuses 100 sind die Ausformungen 18 in Form der gebogenen Verbindungsabschnitte 18c angeordnet, welche die Schutzelemente 13 der zweiten Schutzelementgruppe mit einer Innenseite bzw. Innenwand der Rückseite 15 bzw. der Rückwand des Grundgehäuses 100 verbinden bzw. an dieser befestigen.

### Bezugszeichenliste

- 100: Grundgehäuse

- 10: Schutzeinrichtung
- 11: Luftdurchtrittsöffnung
- 12: Schutzelemente der ersten Schutzelementgruppe
- 13: Schutzelemente der zweiten Schutzelementgruppe
- 14: Filterelement
- 14a, b: Falten des Filterelements
- 14c: Endabschnitt des Filterelements
- 15: Rückseite
- 16: Umfangsseitenwand
- 17: Innenwand
- 18: Ausformung
- 18a: Seitenfläche
- 18b: Verbindungsabschnitt
- 19: Aufnahmeraum

- 20: Wand
- 21: Gehäusedeckel

- RE: Rückseitenebene
- A1: erste Anlageebene
- A2: zweite Anlageebene

## Patentansprüche

1. Grundgehäuse (100) für einen Filterlüfter oder einen Austrittsfilter, aufweisend eine flächige Schutzeinrichtung (10), welche eine Luftdurchtrittsöffnung (11) des Grundgehäuses (100) abdeckt, wobei die Schutzeinrichtung (10) wenigstens eine erste Schutzelementgruppe aufweist, deren Schutzelemente (12) eine erste Anlageebene (A1) für ein in dem Grundgehäuse (100) anordbares Filterelement (14) aufspannen, wobei das Grundgehäuse (100) an einer Luftdurchtrittsseite eine Rückseite (15) mit einer Rückseitenebene (RE) aufweist, wobei die erste Anlageebene (A1) relativ zur Rückseitenebene (RE) zum Inneren des Grundgehäuses (100) hin versetzt angeordnet ist.

2. Grundgehäuse (100) nach Anspruch 1, wobei die Schutzelemente (12) der ersten Schutzelementgruppe Streben, Stangen oder Lamellen sind.

3. Grundgehäuse (100) nach einem der vorgenannten Ansprüche, wobei die Schutzelemente (12) der ersten Schutzelementgruppe horizontal oder vertikal angeordnet sind bezogen auf einen Einbauzustand des Grundgehäuses (100).

4. Grundgehäuse (100) nach einem der vorgenannten Ansprüche, wobei die Schutzeinrichtung (10) eine zweite Schutzelementgruppe aufweist, deren Schutzelemente (13) eine zweite Anlageebene (A2) aufspannen für das in dem Grundgehäuse (100) anordbare Filterelement (14), wobei die zweite Anlageebene (A2) relativ zur ersten Anlageebene (A1) zum Inneren des Grundgehäuses (100) hin versetzt angeordnet ist.

5. Grundgehäuse (100) nach Anspruch 4, wobei die Schutzelemente (13) der zweiten Schutzelementgruppe Streben, Stangen, Lamellen oder sich von den Schutzelementen (12) der ersten Schutzelementgruppe erstreckende Vorsprünge sind.

6. Grundgehäuse (100) nach Anspruch 4 oder 5, wobei die Schutzelemente (13) der zweiten Schutzelementgruppe horizontal oder vertikal angeordnet sind bezogen auf einen Einbauzustand des Grundgehäuses (100), wobei die Schutzelemente (13) der zweiten Schutzelementgruppe bevorzugt senkrecht zu den Schutzelementen (12) der ersten Schutzelementgruppe angeordnet sind.

7. Grundgehäuse (100) nach einem der Ansprüche 4 bis 6, wobei die Schutzelemente (12) der ersten Schutzelementgruppe und die Schutzelemente der zweiten Schutzelementgruppe (13) miteinander verbunden sind.

8. Grundgehäuse (100) nach einem der vorgenannten Ansprüche, aufweisend ein Filterelement (14), wobei das Filterelement (14) in der ersten Anlageebene (A1) an den Schutzelementen (12) der ersten Schutzelementgruppe anliegt.

9. Grundgehäuse (100) nach einem der Ansprüche 4 bis 7, aufweisend ein Filterelement (14), wobei das Filterelement (14) in der zweiten Anlageebene (A2) an den Schutzelementen (13) der zweiten Schutzelementgruppe anliegt.

10. Grundgehäuse (100) nach Anspruch 8 oder 9, wobei das Filterelement (14) ein ebenes Filterelement oder ein Faltenfilterelement ist.

11. Grundgehäuse (100) nach einem der Ansprüche 4 bis 8, wobei das Filterelement (14) ein Faltenfilterelement ist, welches an den Schutzelementen (12) der ersten Schutzelementgruppe anliegt und wobei die Schutzelemente (13) der zweiten Schutzelementgruppe sich in Falten (14a) des Faltenfilterelements erstrecken.

12. Grundgehäuse (100) nach einem der Ansprüche 4 bis 7, aufweisend ein Filterelement (14), wobei das Filterelement (14) in der zweiten Anlageebene (A2) an den Schutzelementen (13) der zweiten Schutzelementgruppe anliegt, wobei das Filterelement (14) ein ebenes Filterelement ist.

13. Grundgehäuse (100) nach einem der vorgenannten Ansprüche, aufweisend eine Ausformung (18), wobei zwischen der Ausformung (18) und einer Innenwand (17) des Grundgehäuses (100) wenigstens ein Aufnahmeraum (19) ausgebildet ist.

14. Grundgehäuse (100) nach Anspruch 13, wobei die Schutzelemente (12, 13) der Schutzeinrichtung (10) an der Ausformung (18) angeordnet sind und/oder wobei das Grundgehäuse (100) ein Filterelement (14) aufweist, wobei sich das Filterelement (14) in den Aufnahmeraum (19) erstreckt.

15. Filterlüfter oder Austrittsfilter, aufweisend ein Grundgehäuse (100) nach einem der vorgenannten Ansprüche.
